(19) Europäisches Patentamt
European Patent Office
Office européen des brevets

(11) Veröffentlichungsnummer : **0 126 875**
**B1**

(12) # EUROPÄISCHE PATENTSCHRIFT

(45) Veröffentlichungstag der Patentschrift : **27.05.87**

(51) Int. Cl.⁴ : **G 03 F 7/08**, C 08 G 12/08

(21) Anmeldenummer : **84103028.1**

(22) Anmeldetag : **20.03.84**

(54) **Lichtempfindliches, Diazoniumgruppen enthaltendes Polykondensationsprodukt, Verfahren zu seiner Herstellung und lichtempfindliches Aufzeichnungsmaterial, das dieses Polykondensationsprodukt enthält.**

(30) Priorität : **29.03.83 DE 3311435**

(43) Veröffentlichungstag der Anmeldung : **05.12.84 Patentblatt 84/49**

(45) Bekanntmachung des Hinweises auf die Patenterteilung : **27.05.87 Patentblatt 87/22**

(84) Benannte Vertragsstaaten : **AT BE CH DE FR GB IT LI NL SE**

(56) Entgegenhaltungen :
**US-A- 3 679 419**
**US-A- 3 849 392**
**US-A- 3 867 147**

(73) Patentinhaber : **HOECHST AKTIENGESELLSCHAFT**
**Postfach 80 03 20**
**D-6230 Frankfurt am Main 80 (DE)**

(72) Erfinder : **Lutz, Walter, Dr.**
**Herderstrasse 21**
**D-6203 Hochheim (DE)**
Erfinder : **Steppan, Hartmut, Dr.**
**Panoramastrasse 17**
**D-6200 Wiesbaden-Dotzheim (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 126 875 B1

Jouve, 18, rue St-Denis, 75001 Paris, France

**Beschreibung**

Die Erfindung betrifft neue lichtempfindliche Polykondensationsprodukte aromatischer Diazoniumsalze, die nach einem neuen Kondensationsverfahren hergestellt werden, sowie lichtempfindliche Aufzeichnungsmaterialien, deren Aufzeichnungsschichten die genannten Polykondensationsprodukte enthalten.

Es ist bekannt, Polykondensationsprodukte durch Umsetzen von aromatischen Diazoniumsalzen, insbesondere Diphenylamin-4-diazoniumsalzen, mit aktiven Carbonylverbindungen, vorzugsweise Formaldehyd, herzustellen. Derartige Kondensationsprodukte sind in der US-A-2 063 631 beschrieben. Ihre Verwendungsmöglichkeiten sind z. B. in der US-A-3 235 383 beschrieben.

Solche Kondensationsprodukte werden in großem Umfang zur Herstellung von Druckformen genutzt. Dabei haben sich praktisch ausschließlich Produkte durchgesetzt, zu deren Kondensation als Carbonylverbindung Formaldehyd verwendet wird.

Obwohl die Formaldehydkondensationsprodukte noch immer in großem Umfang hergestellt und verwendet werden, weisen sie den Nachteil auf, daß sich ihre Zusammensetzung und Eigenschaften nur in geringem Maße variieren lassen. Bei der Verwendung dieser Produkte zur Herstellung von Flachdruckformen reicht normalerweise die Oleophilie ihrer Lichthärtungsprodukte allein nicht aus. Man verstärkt deshalb häufig die entwickelte Bildschablone durch Lackieren mit einer Lösung eines oleophilen Harzes. Auch kann man der Schicht von vornherein solche Harze zusetzen, doch ist dann zumeist der Zusatz organischer Lösungsmittel zum Entwickler erforderlich.

Das Problem der Variierbarkeit hat man in neuerer Zeit dadurch gelöst, daß man gemischte Kondensationsprodukte hergestellt hat, zu deren Herstellung außer der Carbonylverbindung und dem Diazoniumsalz eine weitere, mit Formaldehyd kondensationsfähige Zweitkomponente eingesetzt wird.

Diese Produkte und ihre Anwendung sind in der US-A-3 867 147 beschrieben. Sie lassen sich mit Vorteil auch durch Kondensation des Diazoniumsalzes mit einer reaktive Methylolgruppen bzw. deren Ester bzw. Ether tragenden Zweitkomponente herstellen, wobei die reaktiven Gruppen im einfachsten Fall durch Umsetzen der Zweitkomponente mit Formaldehyd eingeführt werden. Diese Kondensationsprodukte liefern hochwertige strahlungsempfindliche Materialien, insbesondere Druckplatten, und werden in großem Umfang technisch genutzt.

Ein Nachteil dieser Kondensationsprodukte ist jedoch, daß beim Belichten von bindemittelfreien Schichten aus bevorzugten Vertretern dieser Kondensate nicht alle Diazogruppen zersetzt werden. Dies bewirkt eine geringere Oleophilie. Weiterhin können die unzersetzten Diazoniumgruppen mit dem zur Konservierung verwendeten hydrophilen Polymeren unter Lichteinfluß zu farbabstoßenden Reaktionsprodukten reagieren.

Man kann zwar im Kondensationsprodukt den Gehalt an oleophiler Zweitkomponente steigern und erhält dann oleophilere Kondensate, die jedoch schwerer entwickelbar und weniger lagerfähig sind als die sonst bevorzugten Vertreter.

In der hier genannten Druckschrift wird in Spalte 8, Zeilen 32-42, eine weitere Variationsmöglichkeit zur Herstellung der Kondensationsprodukte genannt, die darin besteht, monofunktionelle und bi- oder polyfunktionelle Zweitkomponenten mit dem Diazoniumsalz zu kondensieren und dadurch das Molekulargewicht der Polykondensationsprodukte zu begrenzen. Eine monofunktionelle Zweitkomponente wird nur im Beispiel 23 eingesetzt und dort mit Formaldehyd kombiniert.

Im wesentlichen die gleiche Offenbarung findet sich auch in den US-A 3 679 419 und 3 849 392.

In der EP-A 61 150 wird durch Eigenkondensation der Zweitkomponente und anschließende Umsetzung mit einer monomeren Diazoverbindung ein sehr lichtempfindliches und oleophiles Kondensationsprodukt erhalten. Es ist jedoch in der Lichtempfindlichen Schicht ebenfalls weniger lagerfähig und schwerer zu entwickeln.

Aufgabe der Erfindung war es, neue Polykondensationsprodukte aus aromatischen Diazoniumsalzen und damit kondensationsfähigen Zweitkomponenten vorzuschlagen, die im wesentlichen alle Vorteile der bekannten Kondensationsprodukte wie Lichtempfindlichkeit, Lagerfähigkeit, Entwickelbarkeit aufweisen und zusätzlich Lichthärtungsprodukte mit höherer Oleophilie ergeben.

Erfindungsgemäß wird ein lichtempfindliches, Diazoniumgruppen enthaltendes Polykondensationsprodukt vorgeschlagen, das durch Kondensation aus

a) einem Diazoniumsalz der allgemeinen Formel I

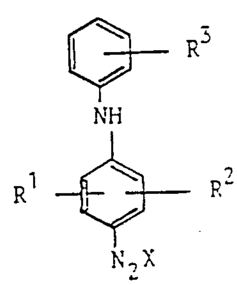

(I)

worin

$R^1$, $R^2$ und $R^3$ Wasserstoffatome, Halogenatome, Alkylgruppen mit 1 bis 3 Kohlenstoffatomen oder Alkoxygruppen mit 1 bis 6 Kohlenstoffatomen bedeuten und

X das Anion des Diazoniumsalzes ist,

b) einer Verbindung der allgemeinen Formel II

$$R^4—O—CH_2—R^5 \qquad (II)$$

worin

$R^4$ ein Wasserstoffatom, eine Alkylgruppe oder ein aliphatischer Acylrest und

$R^5$ ein ein- oder mehrkerniger aromatischer Rest, der unsubstituiert oder durch Halogenatome, Alkylgruppen, halogenierte Alkylgruppen oder Alkoxygruppen mit jeweils 1 bis 3 Kohlenstoffatomen, Carboxy-, Phenyl-, Phenylmercapto- oder Phenoxygruppen substituiert ist, und

c) einer Verbindung der allgemeinen Formel III

$$R^6—O—CH_2—R^8—CH_2—O—R^7 \qquad (III)$$

worin

$R^6$ und $R^7$ Wasserstoffatome, Alkylgruppen oder aliphatische Acylreste sind und

$R^8$ der Rest eines aromatischen Kohlenwasserstoffs, eines Phenols, Phenolethers, aromatischen Thioethers, einer aromatischen heterocyclischen Verbindung oder eines organischen Säureamids ist, wobei zuerst die Verbindung II mit dem Diazoniumsalz I und das erhaltene Reaktionsprodukt danach mit der Verbindung III umgesetzt worden ist.

Erfindungsgemäß wird ferner ein Verfahren zur Herstellung eines lichtempfindlichen Diazoniumsalz-Polykondensationsprodukts der zuvor angegebenen Zusammensetzung vorgeschlagen, das dadurch gekennzeichnet ist, daß in stark saurem Medium ein Diazoniumsalz der Formel I

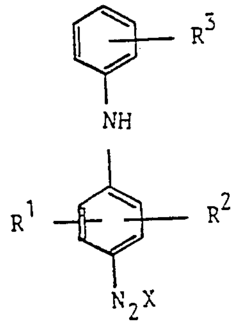

(I)

worin

$R^1$, $R^2$ und $R^3$ Wasserstoffatome, Halogenatome, Alkylgruppen mit 1 bis 3 Kohlenstoffatomen oder Alkoxygruppen mit 1 bis 6 Kohlenstoffatomen bedeuten und

X das Anion des Diazoniumsalzes ist,

zuerst mit einer Verbindung der Formel II

$$R^4—O—CH_2—R^5 \qquad (II)$$

worin

$R^4$ ein Wasserstoffatom, eine Alkylgruppe oder ein aliphatischer Acylrest und

$R^5$ ein ein- oder mehrkerniger aromatischer Rest, der unsubstituiert oder durch Halogenatome, Alkylgruppen, halogenierte Alkylgruppen oder Alkoxygruppen mit jeweils 1 bis 3 Kohlenstoffatomen, Carboxy-, Aryl-, Arylmercapto- oder Aryloxygruppen substituiert ist,

und danach mit einer Verbindung der Formel III

$$R^6—O—CH_2—R^8—CH_2—O—R^7 \qquad (III)$$

kondensiert wird, worin

$R^6$ und $R^7$ Wasserstoffatome, Alkylgruppen oder aliphatische Acylreste sind und

$R^8$ der Rest eines aromatischen Kohlenwasserstoffs, eines Phenols, Phenolethers, aromatischen Thioethers, einer aromatischen heterocyclischen Verbindung oder eines organischen Säureamids ist.

Erfindungsgemäß wird schließlich auch ein lichtempfindliches Aufzeichnungsmaterial aus einem Schichtträger und einer lichtempfindlichen Schicht vorgeschlagen, die als lichtempfindliche Verbindung ein Diazoniumsalz-Polykondensationsprodukt der oben angegebenen Zusammensetzung enthält.

Beispiele für Grundkörper, von denen sich die erfindungsgemäß eingesetzten kondensationsfähigen Verbindungen II und III ableiten, sind Benzol, Biphenyl, Diphenylether, Diphenylsulfid, Diphenylmethan,

Naphthalin, Anthracen, Thiophen, Harnstoff, Oxalsäureamid oder Bernsteinsäureamid. Die aromatischen Grundkörper können weitere Substituenten, z. B. Alkyl-, Alkoxy- oder Hydroxygruppen, tragen.

Mit vorstehender Aufzählung sind die wichtigsten Stoffgruppen, welche die Reste $R^5$ und $R^8$ bilden können, genannt. Weitere Möglichkeiten finden sich in der US-A-3 867 147 bzw. Houben-Weyl « Methoden der organischen Chemie», 4. Auflage Bd. 14/2, S. 193-402, «Polyadditions- bzw. Kondensationsprodukte von Carbonyl- und Thiocarbonylverbindungen».

Bei der Herstellung der Kondensationsprodukte kann man beide Kondensationsreaktionen nacheinander im gleichen Kondensationsmedium unter relativ milden Bedingungen, wie sich auch für die bekannte Herstellung von Mischkondensationsprodukten üblich sind, durchführen. Dabei ist wesentlich, daß die angegebene Reihenfolge der Kondensationsstufen eingehalten wird. Es ist jedoch nicht notwendig, das Produkt der ersten Kondensationsstufe zu isolieren, man kann also beide Reaktionen in einem « Eintropfverfahren » durchführen.

Es ist also notwendig, daß zuerst die Umsetzung des Diazoniumsalzes I mit der monofunktionellen Verbindung II und erst danach die Reaktion mit der bifunktionellen Verbindung III erfolgt. Nur unter diesen Reaktionsbedingungen ist sichergestellt, daß in Wasser klar lösliche Rohkondensate erhalten werden. Als Komponenten II kommen z. B. die folgenden Verbindungen bzw. deren Ether mit kurzkettigen Alkoholen oder deren Ester mit kurzkettigen aliphatischen Carbonsäuren in Betracht.

Benzylalkohol, 4-Methyl-benzylalkohol, 4-Isopropyl-benzylalkohol, 4-Methoxy-benzylalkohol, 4-Carboxy-benzylalkohol, 4-Phenyl-benzylalkohol, 4-Phenoxy-benzylalkohol, 4-p-Tolyloxy-benzylalkohol, 4-o-Tolyloxy-benzylalkohol, 4-Chlorphenoxy-benzylalkohol, Benzhydrol, 4-Phenylmercapto-benzylalkohol, 4-Fluor-benzylalkohol, 3-Fluor-benzylalkohol, 2-Fluor-benzylalkohol, 4-Chlor-benzylalkohol, 3-Chlorbenzylalkohol, 2-Chlor-benzylalkohol und 2-Fluor-6-chlorbenzylalkohol, 2-Hydroxymethyl-naphthalin, 4-Hydroxymethylthiophen, 1-Hydroxymethyl-diphenylenoxid, N-Hydroxymethyl-benzoesäureamid, N-Hydroxymethyl-harnstoff und 2-Hydroxy-hydroxymethyl-benzol.

Bevorzugt werden Verbindungen II, in denen $R^5$ ein gegebenenfalls durch Halogenatome, Alkylgruppen, Halogenalkylgruppen, Alkoxygruppen mit 1 bis 3 Kohlenstoffatomen, Phenyl-, Tolyl-, Phenylmercapto-, Phenoxy- oder Tolyloxygruppen substituierter Phenylrest ist.

Hiervon werden die Verbindungen bevorzugt, die, soweit sie substituiert sind, den Substituenten in p-Stellung besitzen.

Die Reaktivität der Hydroxymethyl- bzw. der Methoxy-methyl- und der Acetoxymethylgruppe ist im sauren Kondensationsmedium vergleichbar.

Als Diphenylamin-4-diazoniumsalze werden in an sich bekannter Weise substituierte oder nicht substituierte Verbindungen verwendet. Bevorzugt werden die unsubstituierten oder die durch eine Alkyl- oder besonders eine Alkoxygruppe mit 1 bis 3 Kohlenstoffatomen substituierten Diphenylamin-4-diazoniumsalze eingesetzt. Besonders vorteilhaft sind die Verbindungen, in denen die Alkyl- bzw. Alkoxygruppe in der 3-Stellung steht. Beispiele für geeignete Diazoniumverbindungen sind diejenigen, die sich von den folgenden Aminen ableiten :

4-Amino-3-methoxy-diphenylamin, 4-Amino-diphenylamin, 4′-Amino-2-methoxy-diphenylamin, 4′-Amino-4-methoxy-diphenylamin, 4-Amino-3-methyl-diphenylamin, 4-Amino-3-ethyl-diphenylamin, 4′-Amino-4-methyl-diphenylamin,

4-Amino-3-hexyloxy-diphenylamin, 4-Amino-3-ethoxy-diphenylamin, 4′-Amino-2-methoxy-5-methyl-diphenylamin,

4′-Amino-3,3′-dimethyl-diphenylamin, 3′-Chlor-4-amino-diphenylamin, 4′-Amino-4-n-butoxy-diphenylamin,

4′-Amino-3′,4-dimethoxy-diphenylamin und 4′-Brom-4-amino-diphenylamin.

Bevorzugt werden 4-Amino-diphenylamin und 3-Methyl-4-amino-diphenylamin. Besonders bevorzugt wird das 3-Methoxy-4-amino-diphenylamin. Als Anion des Diazoniumsalzes wird bevorzugt das Hydrogensulfat verwendet. Die Reaktion findet in stark saurem Medium statt.

Geeignete Kondensationsmittel sind Phosphorsäure, Methansulfonsäure und Schwefelsäure, die in Konzentrationen von mindestens 40, vorzugsweise 70 bis 100, Gewichtsprozent verwendet werden. Der Rest ist im allgemeinen Wasser, kann aber auch ganz oder teilweise aus organischen Lösemitteln, z. B. Methanol, Essigsäure, N-Methyl-pyrrolidon und dergleichen, bestehen. Gute Ergebnisse erhält man beispielsweise, wenn man 85 bis 93 %ige Phosphorsäure, 80 %ige Schwefelsäure und 90 %ige Methansulfonsäure oder Mischungen dieser Säuren verwendet.

80 bis 100 %ige, insbesondere 85 bis 93 %ige Phosphorsäure, ist ein ziemlich mildes Kondensationsmittel, in dem die Kondensation auf sehr schonende Weise durchgeführt werden kann. Es ist deshalb das bevorzugte Kondensationsmittel für alle Kombinationen von Verbindungen, die unter diesen ziemlich schonenden Bedingungen schnell genug reagieren.

80 bis 100 %ige, insbesondere 90 %ige Methansulfonsäure, ist ein stärkeres Mittel.

Vorzugsweise verfährt man so, daß man einerseits so wenig Säure wie möglich verwendet und andererseits ein leicht rührbares und leicht mischbares Kondensationsgemisch erhält. Bei der Auswahl des Typs und der Menge der zu verwendenden Säure sollte man auf die Kondensationsfähigkeit und Löslichkeit der Komponenten in der Säure achten.

Die Kondensation wird im allgemeinen bei Temperaturen von etwa 0 bis 70 °C, vorzugsweise von 10 bis 50 °C, durchgeführt.

Im allgemeinen werden die neuen Polykondensationsprodukte in Form eines Salzes abgeschieden und in dieser Form nach Zusatz der gewünschten weiteren Schichtbestandteile zur Herstellung der Beschichtungslösung verwendet.

Die Polykondensationsprodukte können z. B. als Salze folgender Säuren abgeschieden und verwendet werden :

Halogenwasserstoffsäuren, wie Fluorwasserstoffsäure, Chlorwasserstoffsäure, Bromwasserstoffsäure ; Schwefelsäure, Salpetersäure, Phosphorsäuren (5-wertiger Phosphor), besonders Orthophosphorsäure, anorganische Iso- und Heteropolysäuren, z. B. Phosphorwolframsäure, Phosphormolybdänsäure, aliphatische oder aromatische Phosphonsäuren bzw. deren Halbester, Arsonsäuren, Phosphinsäuren, Trifluoressigsäure, Amidosulfonsäure, Selensäure, Borfluorwasserstoffsäure, Hexafluorphosphorsäure, Perchlorsäure, ferner aliphatische und aromatische Sulfonsäuren, z. B. Methansulfonsäure, Benzolsulfonsäure, Toluolsulfonsäure, Mesitylensulfonsäure, p-Chlorbenzolsulfonsäure, 2,5-Dichlorbenzolsulfonsäure, Sulfosalicylsäure, Naphthalin-1-sulfonsäure, Naphthalin-2-sulfonsäure, 2,6-Di-tert.-butyl-naphthalindisulfonsäure, 1,8-Dinitro-naphthalin-3,6-disulfonsäure, 4,4'-Diazido-stilben-3,3'-disulfonsäure, 1,2-Naphthochinon-2-diazid-4-sulfonsäure, 1,2-Naphthochinon-2-diazid-5-sulfonsäure und 1,2-Naphthochinon-1-diazid-4-sulfonsäure.

Weitere organische Sulfonsäuren, die zur Abscheidung der Kondensate in Betracht kommen, sind in den Spalten 2 bis 5 der US-A-3 219 447 angegeben.

Besonders bevorzugt werden Mesitylensulfonsäure, Naphthalin-2-sulfonsäure oder Methansulfonsäure.

Für die Herstellung der Diazopolykondensate werden gewöhnlich 0,1 bis 1,5 Mol Verbindung II und 0,5 bis 1,5 Mol Verbindung III je Mol Diazoniumsalz verwendet. Bevorzugt werden 0,5 bis 1,2 Mol II und 0,8 bis 1,3 Mol III je Mol Diazoniumsalz eingesetzt.

Ganz allgemein werden etwa 0,4 bis 3, bevorzugt 0,8 bis 2 Mol an Zweitkomponenten (II + III) je Mol Diazoniumsalz I eingesetzt. Dabei sollte das Molverhältnis von II : III 0,2 bis 2 : 1, vorzugsweise 0,6 bis 1,2 : 1 betragen.

Diazopolykondensate mit einer geringeren Konzentration an Verbindung II zeigen in Druckschichten bei gleicher Lichtempfindlichkeit eine schlechtere Farbannahme beim Andruck.

Weiterhin besitzen Kondensate, die auf 1 Mol Diazoniumsalz bis zu 1,3 Mol an Verbindung II und mehr als 1,5 Mol Verbindung III enthalten, in der lichtempfindlichen Schicht eine geringere Lagerfähigkeit.

Ein Vorteil vieler nach dem erfindungsgemäßen Verfahren hergestellter Kondensate besteht darin, daß sie auch in Form von Salzen, die von komplexbildenden Metallsalzen frei sind, leicht abgetrennt werden können. Zum Beispiel bilden viele Kondensate Sulfate, Chloride und Bromide, die in Wasser schwerlöslich sind und aus wäßrigen Lösungen der Kondensationsgemische durch Zugabe der entsprechenden Säuren oder ihrer in Wasser löslichen Salze leicht ausgefällt werden können. Das Abtrennungsverfahren wird in den später folgenden Beispielen im einzelnen beschrieben.

Die erfindungsgemäßen Polykondensationsprodukte zeichnen sich durch eine Reihe von Vorteilen gegenüber den bekannten Diazoniumsalz-Polykondensationsprodukten aus. So lassen sie sich im Vergleich zu den älteren Kondensationsprodukten aus Formaldehyd und Diazoniumsalz leichter aus dem Kondensationsmedium abscheiden und damit besser in reiner Form isolieren. Die damit hergestellten lichtempfindlichen Aufzeichnungsmaterialen, insbesondere Druckplatten, weisen eine geringere Empfindlichkeit gegen Fingerabdrücke auf und haben allgemein eine höhere Lichtempfindlichkeit.

In diesen Eigenschaften entsprechen sie im wesentlichen den Mischkondensationsprodukten, die in der US-PS 3 867 147 beschrieben sind. Gegenüber diesen qualitativ hochwertigen Produkten haben die erfindungsgemäßen Produkte den Vorteil, daß sie einen stärker ausgeprägten Bindemittelcharakter haben. Dies bewirkt eine stärkere Oleophilie, die sich in einer besseren Farbannahme bemerkbar macht.

Versucht man diese Eigenschaft des Kondensates durch Steigerung des Anteils der in der US-A-3 867 147 beschriebenen Zweitkomponenten mit 2 und mehr reaktiven Gruppen gegenüber dem Anteil an den Diazoniumsalzgruppen zu erhalten, so bekommt man Produkte, welche Schichten mit geringerer Lagerfähigkeit liefern.

Rohkondensate mit einem erheblichen Anteil an wasserunlöslichem Kondensat erhält man, wenn man beide kondensierbare Verbindungen II und III gleichzeitig zu der bereits im Kondensationsmedium befindlichen Diazoverbindung gibt.

Die Rohkondensate enthalten auch dann hohe wasserunlösliche Anteile, wenn die Diazoverbindung I zuerst mit III umgesetzt wird und die Kondensation mit II als zweite Stufe vorgenommen wird.

Zur Herstellung von Kopiermaterialien löst man die Diazoniumsalz-Polykondensate für sich allein oder gegebenenfalls zusammen mit weiteren Schichtbestandteilen in einem geeigneten Lösungsmittel und beschichtet mit der so erhaltenen Lösung den vorgesehenen Träger. Bei der Herstellung von Offsetdruckplatten handelt es sich hierbei bevorzugt um metallische Trägermaterialien, insbesondere Aluminium. Dieses wird zuvor im allgemeinen mechanisch oder elektrochemisch aufgerauht, ggf. anodisch oxydiert und ggf. mit einer Lösung von Silikaten, bestimmten Komplexsalzen, Phosphonsäuren oder anderen bekannten Mitteln vorbehandelt.

Die lichtempfindliche Schicht wird bei Raumtemperatur oder bei erhöhter Temperatur angetrocknet.

Den Kopierschichten können als weitere Bestandteile noch eine Vielzahl von Stoffen zugesetzt werden. Als Beispiele seien genannt :

Säuren : z. B. Phosphorsäure (besonders Orthophosphorsäure), Phosphonsäuren, Phosphinsäuren ; die in der US-Patentschrift 3 235 382 genannten starken Säuren, wie Schwefelsäure oder organische Sulfonsäuren, z. B. Toluolsulfonsäure ; organische Polysäuren, z. B. Polyvinylphosphonsäure.

Wasserlösliche Polymerisate : z. B. Polyvinylalkohol, teilweise verseiftes Polyvinylacetat (Acetylgehalt : bis 40 %) und Polyacrylamid.

Wasserunlösliche Polymerisate : z. B. Phenolharze, Epoxyharze, Harnstoff- und Melamin-Harze, Polyvinylacetale, Polyurethane und Polysulfonylurethane. Druckformen mit beträchtlich höheren Druckauflagen erhält man aus Kopierschichten, welche die Polykondensate in Kombination mit Polyvinylformalharzen enthalten. Bevorzugt werden bindemittelfreie Rezepturen, da sie mit wäßrigen Lösungen entwickelbare Schichten ergeben.

Weitere Zusätze
Farbpigmente
Farbstoffe
Weichmacher
Netzmittel

Alle Zusätze sollten so ausgewählt werden, daß sie mit den Diazokondensaten verträglich sind und außerdem in dem für die Lichtzersetzung der Diazoverbindungen wichtigen Wellenlängenbereich möglichst wenig absorbieren.

Die Zusätze werden im allgemeinen in den folgenden Mengen verwendet :

Säuren des fünfwertigen Phosphors werden im allgemeinen in einer Menge von 0,01 bis 4 Mol pro Mol Diazogruppe angewendet. Die organischen Polysäuren, soweit sie gut wasserlöslich sind, finden dagegen im allgemeinen nur in einer Menge von 0,01 bis 3 Mol pro Mol Diazogruppe Verwendung.

Die wasserlöslichen Polymeren werden im allgemeinen in einer Menge bis zu 100 Gewichtsteilen je Gt. Diazopolykondensat, vorzugsweise bis zu 20 Gt. eingesetzt.

Der Zusatz von in Wasser unlöslichen Polymerisaten wird im allgemeinen 15 Gewichtsteile je Gt. Diazoverbindung nicht übersteigen, der bevorzugte Bereich liegt bei 0,5 bis 10 Gt.

Wenn die Kopierschichten wasserlösliche und bzw. oder in Wasser unlösliche Polymerisate enthalten, werden ihnen gefärbte oder ungefärbte Pigmente im allgemeinen nur in einer Menge bis zu 50 Gew.-%, bezogen auf die Polymerisate, zugesetzt.

Weichmacher, Farbstoffe, Netzmittel, Sensibilisatoren, Indikatoren und Fettsäuren werden im allgemeinen in Mengen nicht über 20 Gew.-%, bevorzugt nicht über 10 %, bezogen auf die sonstigen Schichtbestandteile, den Kopierschichten einverleibt.

Als Lösemittel zur Bereitung der Beschichtungslösungen können je nach den Schichtbestandteilen z. B. Wasser, Alkohole, wie Methanol und Ethanol ; Glykolether wie Ethylenglykolmonoethylether ; Dimethylformamid und Diethylformamid verwendet werden.

Reine oder wenig Wasser enthaltende organische Lösemittel werden bevorzugt bei Chloriden, Bromiden und Salzen der neuen Diazokondensate verwendet, die in Wasser weitgehend unlöslich sind, z. B. den Salzen aromatischer Sulfonsäuren, den Tetrafluoroboraten oder den Hexafluorophosphaten. In diesen Fällen setzt man den Alkoholen bzw. Amiden, welche in der Regel gute Lösemittel für diese Verbindungen sind, meist noch Lösemittel zu, die diese nur schlecht lösen, z. B. Ether wie Dioxan, Tetrahydrofuran, Ester wie Essigsäureethylester, Butylacetat, Ethylenglykolmethyletheracetat, Ketone wie Methylethylketon, Cyclohexanon usw., um die Verlaufeigenschaften der Beschichtungen zu verbessern.

Bei der Verarbeitung wird das Kopiermaterial bildmäßig durch eine Vorlage belichtet. Zur Bildbelichtung kann jede in der Reproduktionstechnik gebräuchliche Lichtquelle dienen, die im langwelligen UV-Bereich emittiert, z. B. Kohlenbogenlampen, Quecksilberhochdrucklampen, Xenonimpulslampen und andere. Auch Elektronen- oder Laserstrahlung ist zur Bildaufzeichnung geeignet.

Nach der Belichtung wird mit einem geeigneten Entwickler entwickelt. Als Entwickler können z. B. Wasser, wäßrige Netzmittellösungen, ggf. unter Zusatz von Alkali, deren Gemische mit organischen Lösemitteln, wäßrige Salzlösungen, wäßrige Lösungen von Säuren, z. B. von Phosphorsäuren, denen wiederum Salze oder organische Lösemittel zugesetzt werden können, oder wäßrig-alkalische Entwickler verwendet werden, z. B. wäßrige Lösungen von Natriumsalzen der Phosphorsäure oder der Kieselsäure. Auch diesen Entwicklern können organische Lösemittel zugesetzt werden. Es ist in manchen Fällen auch möglich, mit Wasser verdünnte organische Lösemittel zu verwenden. Die Entwickler können noch weitere Bestandteile, z. B. Netzmittel und Hydrophilierungsmittel, enthalten.

Die Entwicklung erfolgt in bekannter Weise, z. B. durch Tauchen und/oder Überwischen oder Besprühen mit der Entwicklerflüssigkeit. Dabei werden die nicht belichteten Schichtbereiche gelöst.

Die nachstehenden Beispiele beschreiben die Herstellung der neuen Diazopolykondensate und der mit diesen hergestellten erfindungsgemäßen Aufzeichnungsmaterialien. Zur näheren Kennzeichnung der verwendeten Diazokondensate ist neben dem Ergebnis der Elementaranalyse in vielen Beispielen noch das Atomverhältnis angegeben, das aus diesen Analysenwerten errechnet wurde. Aus diesem Verhältniswert sind mit gewissen Einschränkungen Rückschlüsse möglich, in welchem Verhältnis Diazoniumsalz und Cokomponenten am Aufbau des Produkts beteiligt sind. Dieses Verhältnis wurde unter etwas vereinfachenden Annahmen errechnet. Diese Angaben können und sollen keine Aussagen über die genaue Struktur der erfindungsgemäßen Kondensate machen.

Sie reichen jedoch aus zur Identifizierung von Kondensationsprodukten, die in ihren Eigenschaften reproduzierbar sind.

Wie bereits oben erwähnt, sind in vielen Fällen zur weiteren Kennzeichnung die Bedingungen der Kondensation, insbesondere auch die eingesetzten Mengenverhältnisse, wichtig. Die Beispiele enthalten alle für die Herstellung der Kondensate erforderlichen Angaben.

In den Beispielen stehen Gewichtssteile (Gt.) und Volumenteile (Vt.) zueinander im Verhältnis von g zu ml. Prozentangaben sind, wenn nichts anderes angegeben ist, Gewichtsprozente. Temperaturen sind in °C angegeben. Bei den Analysenwerten bedeutet N den Gesamtstickstoffgehalt.

Als « Rohkondensat » wird in den Beispielen im allgemeinen das bei der Kondensation anfallende rohe Kondensationsgemisch bezeichnet, das normalerweise noch das Kondensationsmedium enthält.

## Herstellungsbeispiel 1

In 170 Gt 90 %iger Methansulfonsäure werden 29,2 Gt Diphenylamin-4-diazoniumsulfat gelöst. Zu der Mischung dosiert man 12,2 Gt 4-Methyl-benzylalkohol, kondensiert 2 Stunden bei 40 °C, fügt dann 16,6 Gt 1,4-Bis-methoxy-methyl-benzol hinzu und kondensiert weitere 2 Stunden bei 40 °C. Das Rohkondensat wird in 5 000 Vt Wasser gelöst und danach mit mesitylensulfonsaurem Natrium in die wasserunlösliche Form übergeführt. Es werden 35 Gt Kondensat erhalten.

(C 71,5 % ; N 6,5 % ; S 5,2 % ; C : N : S 38,5 : 3 : 1,05)

## Herstellungsbeispiel 2

In 170 Gt 85 %iger Phosphorsäure werden 32,4 Gt 3-Methoxy-diphenylamin-4-diazoniumsulfat gelöst. In diese Lösung tropft man 22,8 Gt 4-Methyl-4'-methoxymethyl-diphenylether und kondensiert 2 Stunden bei 40 °C. Danach werden 25,8 Gt 4,4'-Bis-methoxymethyl-diphenylether zu dem Gemisch hinzugefügt und weitere 27 Stunden bei 40 °C kondensiert. Das Rohkondensat löst man in 5 000 Vt Wasser. Die Abscheidung des Kondensats erfolgt mit 500 Vt gesättigter Kochsalzlösung. Das Chlorid des Kondensats wird in 800 Vt Wasser gelöst und hieraus mit 300 Vt gesättigter Natriummethansulfonat-Lösung das Methansulfonat ausgefällt. Der Niederschlag wird nach dem Absaugen in 800 Vt Wasser gelöst und mit 300 Vt einer gesättigten Natriummethansulfonat-Lösung wieder ausgefällt. Man erhält 59 Gt Kondensat.

(C 65 % ; N 5,0 % ; S 5,8 % ; C : N : S 45,5 : 3 : 1,52)

## Herstellungsbeispiel 3

In 170 Gt 85 %iger Phosphorsäure werden 32,2 Gt 3-Methoxy-diphenylamin-4-diazoniumsulfat gelöst, 22,8 Gt 4-Methyl-4'-methoxymethyl-diphenylether werden zu der Lösung getropft, und das Gemisch wird danach 2 Stunden bei 40 °C kondensiert. Zu dem Kondensat gibt man dann 25,8 Gt 4,4'-Bis-methoxy-methyl-diphenylether und kondensiert 27 Stunden bei 40 °C. Das Rohkondensat wird in 5 000 Vt Wasser gelöst und mit naphthalin-2-sulfonsaurem Natrium in eine wasserunlösliche Form gebracht. Es werden 76,5 Gt Kondensat erhalten. Es ist sehr gut in Ethylenglykolmonomethylether löslich.

(C 70,5 % ; N 4,7 % ; S 3,6 % ; $OCH_3$ 4,4 % ; C : N : S : $OCH_3$ 52,5 : 3 : 1 : 1,2)

## Herstellungsbeispiele 4 bis 15

Nach dem gleichen Verfahren und bei gleichem Molverhältnis der Ausgangsstoffe werden folgende Diazopolykondensate hergestellt :

(Siehe Tabellen Seite 8 ff.)

| Beispiel | Reaktionsmedium | Diazoverbindung | Verbindung II | Reaktionszeit (Std.) | Verbindung III | Reaktionszeit (Std.) | Fällungsform |
|---|---|---|---|---|---|---|---|
| 4 | I | M | 4-Methylbenzylalkohol | 2 | 4,4'-Bis-methoxymethyl-diphenylether | 15 | Mesitylensulfonat |
| 5 | I | M | 4-Isopropylbenzylalkohol | 2 | 4,4'-Bis-methoxymethyl-diphenylether | 24 | Mesitylensulfonat |
| 6 | I | M | Benzylalkohol | 2 | 4,4'-Bis-methoxymethyl-diphenylether | 16 | Mesitylensulfonat |
| 7 | I | M | 4-Carboxybenzylalkohol | 2 | 4,4'-Bis-methoxymethyl-diphenylether | 16 | Mesitylensulfonat |
| 8 | I | M | 4-Methoxybenzylalkohol | 2 | 4,4'-Bis-methoxymethyl-diphenylether | 15 | Mesitylensulfonat |

| Beispiel | Reaktionsmedium | Diazoverbindung | Verbindung II | Reaktionszeit (Std.) | Verbindung III | Reaktionszeit (Std.) | Fällungsform |
|---|---|---|---|---|---|---|---|
| 9 | I | M | 4-Trifluormethylbenzylalkohol | 2 | 4,4'-Bis-methoxymethyl-diphenylether | 16 | Mesitylensulfonat |
| 10 | I | M | 4-Fluorbenzylalkohol | 2 | 4,4'-Bis-methoxymethyl-diphenylether | 21 | Mesitylensulfonat |
| 11 | I | D | 4-Methyl-4'-methoxymethyldiphenylether | 2 | N,N'-Dimethylolharnstoff | 18 | Naphthalin-2-sulfonat |
| 12 | II | M | 4-Methylbenzylalkohol | 2 | N,N'-Dimethylolharnstoff | 5 | Naphthalin-2-sulfonat |
| 13 | I | M | 4-Methyl-4'-methoxymethyldiphenylether | 2 | 2,6-Dimethylol-p-kresol | 6 | Mesitylensulfonat |

| Beispiel | Reaktionsmedium | Diazoverbindung | Verbindung II | Reaktionszeit (Std.) | Verbindung III | Reaktionszeit (Std.) | Fällungsform |
|---|---|---|---|---|---|---|---|
| 14 | I | M | 4-Methoxy-benzylalkohol | 2 | 4,6-Bis-methoxymethyl-1,3-xylol | 5 | Mesitylen-sulfonat |
| 15 | I | M | 4-Methyl-4'-methoxymethyl-diphenylether | 2 | 4,4'-Bis-methoxymethyl-diphenyl | 26 | Mesitylen-sulfonat |

I 85 %ige Orthophosphorsäure
II 90 %ige Methansulfonsäure
M 3-Methoxy-diphenylamin-4-diazoniumsulfat
D Diphenylamin-4-diazoniumsulfat

| Kondensat von Beispiel | Elementaranalyse (%) | | | | Atomverhältnis | |
|---|---|---|---|---|---|---|
| 4 | C 70,5 | N 5,1 | S 4,1 | | C : N : S | 49 : 3 : 1,07 |
| 5 | C 69,9 | N 5,0 | S 3,7 | | C : N : S | 48 : 3 : 0,97 |
| 6 | C 69,2 | N 5,6 | S 4,3 | | C : N : S | 43 : 3 : 1 |
| 7 | C 68,0 | N 5,8 | S 4,3 | | C : N : S | 41 : 3 : 0,97 |
| 8 | C 69,2 | N 5,1 | S 4,1 | | C : N : S | 48 : 3 : 1,05 |
| 9 | C 64,9 | N 5,2 | S 4,4 | F 6,3 | C : N : S : F | 44 : 3 : 1.1 : 2,7 |
| 10 | C 68,1 | N 5,4 | S 4,2 | F 1,9 | C : N : S : F | 44 : 3 : 1 : 0,8 |
| 11 | C 67,2 | N 8,7 | S 4,5 | | C : N : S | 45 : 5 : 1,1 |
| 12 | C 67,7 | N 8,3 | S 4,5 | | C : N : S | 48 : 5 : 1,2 |
| 13 | C 70,0 | N 5,4 | S 4,4 | | C : N : S | 45 : 3 : 1,07 |
| 14 | C 68,6 | N 5,7 | S 4,6 | | C : N : S | 40 : 3 : 1 |
| 15 | C 72,3 | N 4,9 | S 3,8 | | C : N : S | 52 : 3 : 1 |

Anwendungsbeispiel 16

Die in den Beispielen 1 bis 15 dargestellten Kondensate werden auf einen elektrolytisch aufgerauhten und mit Polyvinylphosphonsäure vorbehandelten Schichtträger aus Aluminium aufgebracht. Anschließend wird die Beschichtung mit Warmluft angetrocknet. Man verwendet hierfür eine Beschichtungslösung folgender Zusammensetzung :

5 Gt Diazopolykondensat
0,5 Gt 85 %ige $H_3PO_4$
0,5 Gt Viktoriareinblau FGA (C.I. 42 595)
95,0 Gt Ethylenglykolmonomethylether

Die Platten werden mit einer 5 kW-Metallhalogenidlampe im Abstand von 100 cm zwischen Lampe und Vakuumkopierrahmen durch eine Negativvorlage 30 Sekunden belichtet. Die Entwicklung des belichteten Materials erfolgt mit einem Entwickler folgender Zusammensetzung :

15 Gt Pelargonsäure
10 Gt NaOH
92 Gt eines Blockcopolymerisats aus 90 % Propylenoxid und 10 % Ethylenoxid
12 Gt Natriumtetrapolyphosphat und
550 Gt Wasser

Anwendungsbeispiel 17 (Vergleichsbeispiel)

Man löst 32,3 Gt 3-Methoxy-diphenylamin-4-diazoniumsulfat in 170 Gt 85 %iger Phosphorsäure, tropft 25,8 Gt 4,4'-Bis-methoxymethyl-diphenylether zu und kondensiert 5 Stunden bei 40 °C. Nach dem Verdünnen mit 250 Vt Wasser fällt man das Chlorid durch Zugabe von 220 Vt halbkonzentrierter Salzsäure aus. Das Chlorid wird in Wasser gelöst, und mit naphthalin-2-sulfonsaurem Natrium erhält man das Naphthalin-2-sulfonat des Diazopolykondensates als eine in Wasser schwerlösliche Verbindung. Ausbeute 53 Gt (C 67,2 %, N 6,3 % ; S 4,6 % ; C : N : S 37,3 : 3 : 0,96). Dieses Kondensat und das in Beispiel 3 beschriebene Kondensat werden entsprechend der in Beispiel 16 angegebenen Rezeptur und Vorschrift auf einen Aluminiumträger aufgebracht. Beide Muster werden in einem Kopierrahmen auf vier gedeckte Stufen mit einem handelsüblichen Stufenkeil belichtet, entwickelt und konserviert. Danach werden beide Muster auf den Zylinder einer Offsetdruckmaschine gespannt und angedruckt. Die Platte, auf der sich das in Beispiel 3 beschriebene Kondensat befindet, hat nach 15 Bögen voll Farbe angenommen, während die Platte mit dem oben beschriebenen Kondensat 80 Bögen zur vollen Farbannahme benötigt.

Herstellungsbeispiel 18 (Vergleichsbeispiel)

Man löst 32,3 Gt 3-Methoxy-diphenylamin-4-diazoniumsulfat in 170 Gt 85 %iger Phosphorsäure, tropft 25,8 Gt 4,4'-Bis-methoxymethyl-diphenylether zu und kondensiert 2 Stunden bei 40 °C. Danach werden 22,8 Gt 4-Methyl-4'-methoxymethyl-diphenylether hinzugefügt, und das Gemisch wird weitere 27 Stunden bei 40 °C kondensiert. Im Verlauf dieses gesamten Zeitraums werden in regelmäßigen Abständen Proben des Reaktionsgemischs entnommen und mit Wasser verdünnt. In keinem Fall wird ein in Wasser auch bei erhöhten Temperaturen klar lösliches Rohkondensat erhalten.

Herstellungsbeispiel 19 (Vergleichsbeispiel)

Man löst 32,3 Gt 3-Methoxy-diphenylamin-4-diazoniumsulfat in 170 Gt 85 %iger Phosphorsäure, tropft eine Mischung aus 25,8 Gt 4,4'-Bis-methoxymethyl-diphenylether und 22,8 Gt 4-Methyl-4'-methoxymethyl-diphenylether zu und kondensiert danach 29 Stunden bei 40 °C. Man erhält während der gesamten Kondensationszeit auch bei erhöhten Temperaturen kein in Wasser klar lösliches Kondensationsprodukt.

Herstellungsbeispiel 20 (Vergleichsbeispiel)

Man löst 32,3 Gt 3-Methoxy-diphenylamin-4-diazoniumsulfat in 170 Gt 85 %iger Phosphorsäure, tropft 51,6 Gt 4,4'-Bis-methoxymethyl-diphenylether zu und kondensiert in parallelen Ansätzen 8 Stunden, 15 Stunden und 26 Stunden bei 40 °C. Man erhält in 5 000 Vt Wasser klar lösliche Rohkondensate. Durch Zusatz von mesitylensulfonsaurem Natrium lassen sich die Kondensate ausfällen. Ausbeuten zwischen 74 und 78 Gt. (C 70,7 %, N 4,6 %, S 3,7 %, $OCH_3$ 4,2 % ; C : N : S : $OCH_3$ 54 : 3 : 1 : 1,2). Die Produkte werden in der in Beispiel 16 beschriebenen Beschichtungsmischung auf ihre Lagerfähigkeit (100 °C-Test) geprüft. Dabei zeigen die Platten mit dem in Beispiel 3 beschriebenen Kondensationsprodukt eine Lagerfähigkeit von 4 Stunden, während die mit den vorstehend beschriebenen Kondensationsprodukten Lagerfähigkeiten zwischen 1 und 2 Stunden ergeben.

Herstellungsbeispiel 21 (Vergleichsbeispiel)

Man löst 32,3 Gt 3-Methoxy-diphenylamin-4-diazoniumsulfat in 170 Gt 85 %iger Phosphorsäure, tropft 12,9 Gt 4,4'-Bis-methoxymethyl-diphenylether zu, kondensiert 2 Stunden bei 40 °C und fügt nun weitere 38,6 Gt 4,4'-Bis-methoxy-methyl-diphenylether zu. In parallelen Ansätzen kondensiert man weitere 24 Stunden, 18 Stunden und 6 Stunden bei 40 °C. Man erhält jeweils ein in 5 000 Vt Wasser klar lösliches Rohkondensat. Durch Zusatz von mesitylensulfonsaurem Natrium lassen sich die Diazopolykondensate ausfällen.

Ausbeuten : 70 bis 76 Gt (C 69,9 %, N 4,7 %, S 4,0 %, C : N : S 52 : 3 : 1,1). Es ist auffällig, daß mit abnehmender Kondensationszeit die als Mesitylensulfonat abgeschiedenen Diazopolykondensate mehr zum Verkleben neigen. Dies zeigt, daß sie für eine technische Verwendung weniger geeignet sind. Weiterhin weisen die mit diesen Kondensaten hergestellten Schichten Lagerfähigkeiten bei 100 °C von nur etwa 2 Stunden unter den Bedingungen des Beispiels 20 auf.

Herstellungsbeispiele 22 bis 24

a) Diazoverbindung : 3-Methoxy-diphenylamin-4-diazoniumsulfat
b) Verbindung II : 4-Carboxy-benzylalkohol
c) Verbindung III : 4,4'-Bis-methoxymethyl-diphenylether

| Beispiel | 22 | 23 | 24 |
|---|---|---|---|
| Molverhältnis a:b:c | 1 : 0,25 : 1 | 1 : 0,75 : 1 | 1 : 1 : 1 |
| Gt a:b:c | 32,3:3,8:25,7 | 32,3 :11,4:25,8 | 32,3:15,2:25,7 |
| Ausbeute | 50 Gt | 55 Gt | 56 Gt |
| Analyse | C 67,2; N 6,0; S 4,7 | C 67,6; N 5,9; S 4,4 | C 68,0; N 5,8; S 4,3 |
| Atomverhältnis | C:N:S 39,4:3:1,03 | C:N:S 41:3:0,98 | C:N:S 42:3:0,98 |

Man löst die Diazoverbindung in 170 Gt 85 %iger Phosphorsäure, tropft den 4-Carboxy-benzylalkohol zu, kondensiert 2 Stunden bei 40 °C, fügt nun 4,4'-Bis-methoxymethyl-diphenylether zu und kondensiert erneut 16 Stunden bei 40 °C. Man gießt das Rohkondensat in 5 000 Vt Wasser, worin es sich rückstandslos löst. Das Kondensat wird als Chlorid mit 220 Vt halbkonzentrierter Salzsäure (1 : 1) gefällt und nach dem Absaugen wieder in 500 Vt Wasser aufgelöst. Mit mesitylensulfonsaurem Natrium kann das Kondensat als wasserunlösliche Verbindung ausgefällt werden.

Beim Andruck zeigen die mit den beschriebenen Kondensaten hergestellten Platten eine vom Beispiels 22 zum Beispiel 24 hin zunehmende Farbannahme :

| Beispiel | Anzahl der Druckbögen bis zur vollständigen Farbannahme |
|---|---|
| 22 | 60 bis 70 |
| 23 | 30 bis 40 |
| 24 | 15 bis 20 |

Anwendungsbeispiel 25

Die in den Beispielen 4 bis 15 beschriebenen Kondensate wurden mit den folgenden in Lösungsmitteln löslichen Harzen zu Beschichtungsgemischen kombiniert :

Polyvinylbutyral, enthaltend 69 bis 71 % Vinylbutyral-, 1 % Vinylacetat- und 24 bis 27 % Vinylalkoholeinheiten ; Viskosität einer 60 %igen Lösung in Methanol bei 20 °C 4 bis 6 mPa · s (DIN 53015).

Nichtplastifiziertes Harnstoffharz der ungefähren Säurezahl 2.

Die Beschichtungsgemische hatten die folgende Zusammensetzung :

1 Gt Kondensationsprodukt
0,1 Gt 85 %ige Phosphorsäure
3 Gt Harz
0,4 Gt Viktoriareinblau FGA
77,0 Gt Ethylenglykolmonomethylether

Sie wurden auf elektrolytisch aufgerauhte und anodisch oxydierte Aluminiumplatten aufgebracht. Die erhaltenen Platten werden nach dem Trocknen 40 Sekunden unter einem Negativ mittels einer Metallhalogenidlampe von 5 kW im Abstand von 1 m bildmäßig belichtet und anschließend durch Überwischen mit einem Entwickler der folgenden Zusammensetzung in Druckformen umgewandelt.

50 Gt Wasser
15 Gt Isopropanol
20 Gt n-Propanol
12,5 Gt n-Propylacetat
1,5 Gt Polyacrylsäure
1,5 Gt Essigsäure

Die Druckformen, besonders die mit Polyvinylbutyral als Bindemittel, weisen eine sehr gute Auflagenstabilität auf.

Anwendungsbeispiel 26

Eine mit dünner Kupferfolie kaschierte Kunststoffplatte wird nach der Reinigung der Kupferoberfläche mit Scheuermittel und Abspülen mit Aceton mit der nachstehenden Lösung beschichtet :

1,0 Gt des in Beispiel 2 beschriebenen Polykondensats
3,0 Gt eines Kresol-Formaldehyd-Novolaks mit einem Erweichungspunkt von 105 bis 120 °C nach DIN 53181
40 Gt Ethylenglykolmonomethylether
0,05 Gt Kristallviolett

Es wird ein Schichtgewicht von 2 g/m$^2$ eingestellt. Die Platte wird unter einem Positiv, welches ein Schaltschema darstellt, 2 Minuten mit einer 5 kW-Metallhalogenid-Lampe im Abstand von 100 cm zwischen Lampe und Vakuumkopierrahmen belichtet. Die Entwicklung erfolgt mit einem Entwickler der folgenden Zusammensetzung :

3 Gt NaOH
3 Gt Natriummetasilikat × 12 $H_2O$
4 Gt Ethylenglykolmonobutylether
90 Gt Wasser

Dabei werden die belichteten Schichtbereiche abgelöst. Durch Wegätzen des Kupfers an den freigelegten Stellen mit 40 %iger wäßriger Eisen-(III)-chlorid-Lösung wird eine kopierte Schaltung erhalten.

Anwendungsbeispiel 27

Das in Beispiel 2 hergestellte Polykondensat läßt sich zur Herstellung einer Siebdruckform verwenden. Dazu gibt man zu 100 Gt einer Siebdruckemulsion, die aus 3 Gt einer 53 %igen Dispersion eines Vinylacetat-Maleinsäureester-Mischpolymerisats und 2 Gt einer 24 %igen Lösung eines Polyvinylalkohols mit dem K-Wert 75 und einem Restacetylgruppengehalt von etwa 12 % bestand, eine Lösung von 0,7 Gt des in Beispiel 2 beschriebenen Polykondensats in 12 Vt Wasser. Die Dispersion wurde mit 5 Vt einer 5 %igen Kristallviolett-Lösung angefärbt. Damit wurde ein Polyestersiebdruckgewebe wie üblich beschichtet, dann getrocknet, belichtet und mit Wasser entwickelt und erneut getrocknet. Die Schicht auf dem Gewebe zeigte eine sehr gute Auflösung und Lichtempfindlichkeit.

**Patentansprüche**

1. Lichtempfindliches, Diazoniumgruppen enthaltendes Polykondensationsprodukt aus

a) einem Diazoniumsalz der allgemeinen Formel I

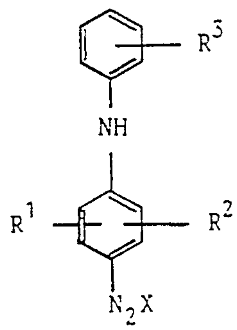

(I)

worin

$R^1$, $R^2$ und $R^3$ Wasserstoffatome, Halogenatome, Alkylgruppen mit 1 bis 3 Kohlenstoffatomen oder Alkoxygruppen mit 1 bis 6 Kohlenstoffatomen bedeuten und

X das Anion des Diazoniumsalzes ist,

b) einer Verbindung der allgemeinen Formel II

$$R^4—O—CH_2—R^5 \quad (II)$$

worin

$R^4$ ein Wasserstoffatom, eine Alkylgruppe oder ein aliphatischer Acylrest und

$R^5$ ein ein- oder mehrkerniger aromatischer Rest, der unsubstituiert oder durch Halogenatome, Alkylgruppen, halogenierte Alkylgruppen oder Alkoxygruppen mit jeweils 1 bis 3 Kohlenstoffatomen, Carboxy-, Phenyl-, Phenylmercapto- oder Phenoxygruppen substituiert ist, und

c) einer Verbindung der allgemeinen Formel III

$$R^6—O—CH_2—R^8—CH_2—O—R^7 \quad (III)$$

worin

$R^6$ und $R^7$ Wasserstoffatome, Alkylgruppen oder aliphatische Acylreste sind und

$R^8$ der Rest eines aromatischen Kohlenwasserstoffs, eines Phenols, Phenolethers, aromatischen Thioethers, einer aromatischen heterocyclischen Verbindung oder eines organischen Säureamids ist, wobei zuerst die Verbindung II mit dem Diazoniumsalz I und das erhaltene Reaktionsprodukt danach mit der Verbindung III umgesetzt worden ist.

2. Polykondensationsprodukt nach Anspruch 1, dadurch gekennzeichnet, daß $R^4$, $R^6$ und $R^7$ Wasserstoffatome oder Alkylgruppen mit 1 bis 3 Kohlenstoffatomen sind.

3. Polykondensationsprodukt nach Anspruch 1, dadurch gekennzeichnet, daß $R^8$ ein Rest mit einem aromatischen Ring oder zwei über eine Einfachbindung oder eine der Gruppen —O—, —NH—, $—CH_2—$, —S— verbundene aromatische Ringe ist.

4. Polykondensationsprodukt nach Anspruch 1, dadurch gekennzeichnet, daß es durch Kondensieren von 1 molaren Anteil Diazoniumsalz (I) mit 0,1 bis 1,5 molaren Anteilen der Verbindung II und 0,5 bis 1,5 molaren Anteilen der Verbindung III erhalten worden ist.

5. Verfahren zur Herstellung eines lichtempfindlichen Diazoniumgruppen enthaltenden Polykondensationsprodukts gemaß Anspruch 1, dadurch gekennzeichnet, daß in stark saurem Medium ein Diazoniumsalz der Formel I

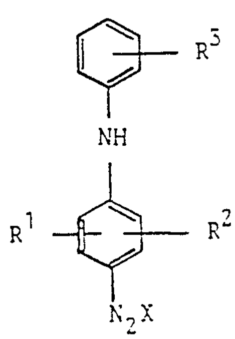

(I)

worin

$R^1$, $R^2$ und $R^3$ Wasserstoffatome, Halogenatome, Alkylgruppen mit 1 bis 3 Kohlenstoffatomen oder Alkoxygruppen mit 1 bis 6 Kohlenstoffatomen bedeuten und

X das Anion des Diazoniumsalzes ist, zuerst mit einer Verbindung der Formel II

$$R^4—O—CH_2—R^5 \qquad (II)$$

worin

$R^4$ ein Wasserstoffatom, eine Alkylgruppe oder ein aliphatischer Acylrest und

$R^5$ ein ein- oder mehrkerniger aromatischer Rest, der unsubstituiert oder durch Halogenatome, Alkylgruppen, halogenierte Alkylgruppen oder Alkoxygruppen mit jeweils 1 bis 3 Kohlenstoffatomen, Carboxy-, Aryl-, Arylmercapto- oder Aryloxygruppen substituiert ist,

und danach mit einer Verbindung der Formel III

$$R^6—O—CH_2—R^8—CH_2—O—R^7 \qquad (III)$$

kondensiert wird, worin

$R^6$ und $R^7$ Wasserstoffatome, Alkylgruppen oder aliphatische Acylreste sind und

$R^8$ der Rest eines aromatischen Kohlenwasserstoffs, eines Phenols, Phenolethers, aromatischen Thioethers, einer aromatischen heterocyclischen Verbindung oder eines organischen Säureamids ist.

6. Lichtempfindliches Aufzeichnungsmaterial aus einem Schichtträger und einer lichtempfindlichen Schicht, die als lichtempfindliche Verbindung ein Diazoniumsalz-Polykondensationsprodukt enthält, dadurch gekennzeichnet, daß die Schicht ein Polykondensationsprodukt gemäß Anspruch 1 enthält.

**Claims**

1. A light-sensitive, diazonium-group containing polycondensation product of

a) a diazonium salt corresponding to the general formula I

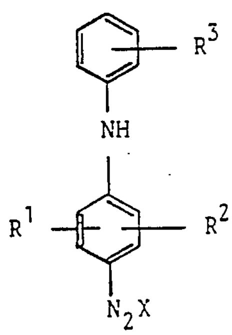

(I)

in which

$R^1$, $R^2$ and $R^3$ denote hydrogen atoms, halogen atoms, alkyl groups having from 1 to 3 carbon atoms or alkoxy groups having from 1 to 6 carbon atoms, and

X denotes the anion of the diazonium salt,

b) a compound corresponding to the general formula II

$$R^4—O—CH_2—R^5 \qquad (II)$$

in which

$R^4$ denotes a hydrogen atome, an alkyl group or an aliphatic acyl radical and

$R^5$ denotes a mononuclear or polynuclear aromatic radical, which is unsubstituted or is substituted by halogen atoms, alkyl groups, halogenated alkyl groups or alkoxy groups which have, in each case, from 1 to 3 carbon atoms ; carboxy, phenyl, phenylmercapto or phenoxy groups, and

c) a compound corresponding to the general formula III

$$R^6—O—CH_2—R^8—CH_2—O—R^7 \qquad (III)$$

in which

$R^6$ and $R^7$ denote hydrogen atoms, alkyl groups or aliphatic acyl radicals and

$R^8$ is the radical of an aromatic hydrocarbon, of a phenol, phenolether, aromatic thioether, of an aromatic heterocyclic compound or of an organic acid amide,

wherein, in a first step, the compound of formula II is reacted with the diazonium salt of formula I and,

thereafter, the reaction product is further reacted with the compound of formula III.

2. A polycondensation product as claimed in claim 1, wherein $R^4$, $R^6$ and $R^7$ comprise hydrogen atoms or alkyl groups having from 1 to 3 carbon atoms.

3. A polycondensation product as claimed in claim 1, wherein $R^8$ comprises a radical having one aromatic ring or two aromatic rings which are linked by a single bond or by one of the groups —O—, —NH—, —$CH_2$— or —S—.

4. A polycondensation product as claimed in claim 1, which has been obtained by condensing 1 molar portion of diazonium salt (I) with 0.1 to 1.5 molar portions of compound II and 0.5 to 1.5 molar portions of compound III.

5. A process for the production of a light-sensitive, diazonium-group containing polycondensation product according to claim 1, wherein a diazonium salt corresponding to formula I

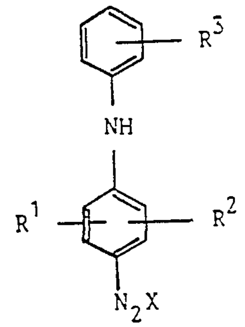

(I)

wherein

$R^1$, $R^2$ and $R^3$ denote hydrogen atoms, halogen atoms, alkyl groups having from 1 to 3 carbon atoms or alkoxy groups having from 1 to 6 carbon atoms, and

X denotes the anion of the diazonium salt,

is condensed in a strongly acid medium, first with a compound corresponding to the general formula II

$$R^4—O—CH_2—R^5 \quad (II)$$

wherein

$R^4$ denotes a hydrogen atom, an alkyl group or an aliphatic acyl radical and

$R^5$ denotes a mononuclear or polynuclear aromatic radical, which is unsubstituted or is substituted by halogen atoms, alkyl groups, halogenated alkyl groups or alkoxy groups which have, in each case, from 1 to 3 carbon atoms, carboxy, aryl, arylmercapto or aryloxy groups, and

thereafter with a compound corresponding to the general formula III

$$R^6—O—CH_2—R^8—CH_2—O—R^7 \quad (III)$$

wherein

$R^6$ and $R^7$ denote hydrogen atoms, alkyl groups or aliphatic acyl radicals and

$R^8$ is the radical of an aromatic hydrocarbon, of a phenol, phenolether, aromatic thioether, of an aromatic heterocyclic compound or of an organic acid amide.

6. A light-sensitive recording material comprising a support and a light-sensitive layer containing as the light-sensitive compound a diazonium-salt polycondensation product, wherein the layer contains a polycondensation product as claimed in claim 1.

**Revendications**

1. Produit de polycondensation photosensible, contenant des groupes diazonium, obtenu à partir de

a) un sel de diazonium de formule générale I

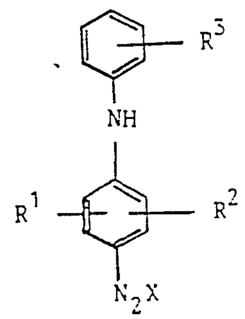

(I)

dans laquelle

$R^1$, $R^2$ et $R^3$ représentent des atomes d'hydrogène, des atomes d'halogène, des groupes alkyle ayant de 1 à 3 atomes de carbone, ou des groupes alcoxy ayant de 1 à 6 atomes de carbone, et

X est l'anion du sel de diazonium,

b) un composé de formule générale II

$$R^4—O—CH_2—R^5 \quad (II)$$

dans laquelle

$R^4$ est un atome d'hydrogène, un groupe alkyle ou un reste acyle aliphatique, et

$R^5$ est un reste aromatique à un ou plusieurs noyaux, qui n'est pas substitué ou qui est substitué par des atomes d'halogène, des groupes alkyle, des groupes alkyle halogénés ou des groupes alcoxy, ayant chacun de 1 à 3 atomes de carbone, des groupes carboxy, phényle, phénylmercapto ou phénoxy, et

c) un composé de formule générale III

$$R^6—O—CH_2—R^8—CH_2—O—R^7 \quad (III)$$

dans laquelle

$R^6$ et $R^7$ sont des atomes d'hydrogène, des groupes alkyle ou des restes acyle aliphatiques, et

$R^8$ est le reste d'un hydrocarbure aromatique, d'un phénol, d'un éther phénolique, d'un thioéther aromatique, d'un composé aromatique hétérocyclique ou d'un amide organique,

en faisant d'abord réagir le composé II avec le sel de diazonium I et ensuite le produit de réaction ainsi obtenu, avec le composé III.

2. Produit de polycondensation selon la revendication 1, caractérisé en ce que $R^4$, $R^6$ et $R^7$ sont des atomes d'hydrogène ou des groupes alkyle ayant de 1 à 3 atomes de carbone.

3. Produit de polycondensation selon la revendication 1, caractérisé en ce que $R^8$ est un reste comportant un noyau aromatique ou deux noyaux aromatiques liés par l'intermédiaire d'une simple liaison ou d'un des groupes —O—, —NH—, —$CH_2$—, —S—.

4. Produit de polycondensation selon la revendication 1, caractérisé en ce qu'il est obtenu par condensation d'une fraction molaire du sel de diazonium I avec 0,1 à 1,5 fraction molaire du composé II et 0,5 à 1,5 fraction molaire du composé III.

5. Procédé pour la préparation d'un produit de polycondensation photosensible contenant des groupes diazonium selon la revendication 1, caractérisé en ce que l'on condense, en milieu fortement acide, un sel de diazonium de formule I

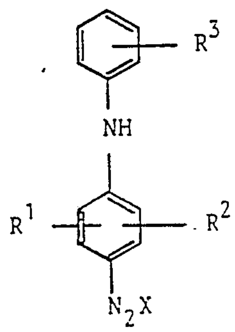

(I)

dans laquelle

$R^1$, $R^2$ et $R^3$ représentent des atomes d'hydrogène, des atomes d'halogène, des groupes alkyle ayant de 1 à 3 atomes de carbone, ou des groupes alcoxy ayant de 1 à 6 atomes de carbone, et

X est l'anion du sel de diazonium,

d'abord avec un composé de formule II

$$R^4—O—CH_2—R^5 \quad (II)$$

dans laquelle

$R^4$ est un atome d'hydrogène, un groupe alkyle ou un reste acyle aliphatique, et

$R^5$ est un reste aromatique à un ou plusieurs noyaux, qui n'est pas substitué ou qui est substitué par des atomes d'halogène, des groupes alkyle, des groupes alkyle halogénés ou des groupes alcoxy, ayant chacun de 1 à 3 atomes de carbone, des groupes carboxy, aryle, arylmercapto ou aryloxy,

et ensuite avec un composé de formule III

$$R^6—O—CH_2—R^8—CH_2—O—R^7 \quad (III)$$

dans laquelle

$R^6$ et $R^7$ sont des atomes d'hydrogène, des groupes alkyle ou des restes acyle aliphatiques, et

$R^8$ est le reste d'un hydrocarbure aromatique, d'un phénol, d'un éther phénolique, d'un thioéther aromatique, d'un composé aromatique hétérocyclique ou d'un amide organique.

6. Matériau d'enregistrement photosensible composé d'un support de couche et d'une couche photosensible qui contient, en tant que composé photosensible, un produit de polycondensation d'un sel de diazonium, caractérisé en ce que la couche contient un produit de polycondensation selon la revendication 1.